# EUROPEAN PATENT SPECIFICATION

(11) **EP 3 028 375 B1**
(45) Date of publication and mention of the grant of the patent: **22.09.2021**
(21) Application number: 13799235.0
(22) Date of filing: 20.11.2013
(51) Int. Cl.: H02M 1/32, G01R 19/14, H02H 7/12

(54) **A HIGH VOLTAGE CONVERTER CIRCUIT EQUIPPED WITH A VOLTAGE MONITORING DEVICE**
HOCHSPANNUNGSUMRICHTERSCHALTUNG MIT EINER SPANNUNGSÜBERWACHUNGSVORRICHTUNG
CIRCUIT DE CONVERTISSEUR HAUTE TENSION ÉQUIPÉ D'UN DISPOSITIF DE SURVEILLANCE DE TENSION

(43) Date of publication of application: 08.06.2016
(73) Proprietor: Siemens Energy Global GmbH & Co. KG, 81739 München (DE)
(72) Inventor: STAHLHUT, Nils, 91341 Röttenbach (DE)
(86) International application number: PCT/EP2013/074286
(87) International publication number: WO 2015/074689

(56) References cited:
- DE-A1-102007 029 388
- US-A- 3 654 541
- US-B1- 8 054 049

## Description

The present invention relates to a high voltage converter circuit and more particularly to a monitoring device for monitoring voltage polarity for a high voltage converter circuit having a plurality of power semiconductor devices.

Thyristors are being widely used in modern day high voltage DC (HVDC) transmission systems. HVDC systems use power electronic converters for power conversion and power quality control. In power converters the power semiconductor devices, like thyristors, are arranged in series forming a network of a plurality of power semiconductor devices. Due to the fact that power semiconductor devices, like thyristors, are not an ideal switch and to properly perform their function in the series connection under all steady state and transient conditions, the power semiconductor devices in high voltage power converters need to be complemented by auxiliary components, e.g. snubber capacitors, snubber resistors, d.c. grading resistors, grading capacitors etc. These high voltage power converters comprising power semiconductor devices also require circuits for monitoring the voltage across the power semiconductor device and determine the polarity of the voltage.

US patent US 6577482 B1 describes one such reverse polarity protective circuit for a series connection of a power semiconductor device by use of a freewheeling circuit. The invention only talks about the sensing of a fault condition at which point the circuit is shut-off.

US patent US 6211792 is another invention which discloses detection of voltage across a thyristor, and indicating a failed short thyristor when the absolute value of the voltage across the thyristor remains below a threshold value during a predetermined period of time.

European Patent EP0575131 discloses a device for controlling a thyristor convertor. In particular it describes a fault detection means. Said convertor includes series connected thyristors. The device comprises a plurality of forward voltage detection means, each for detecting forward voltage of a respective thyristor and generating a forward voltage signal.

Patent US 3,654,541 A discloses a voltage detecting means which is connected in parallel with a thyristor for emitting an indicating signal when the instantaneous magnitude of the voltage across the thyristor exceeds a predetermined threshold level which is higher than the voltage drop across the thyristor when conducting. The voltage detecting means comprises a fullwave diode bridge which a-c terminals are connected via resistors to the terminals of the thyristor. The d-c terminals of the diode bridge are connected with a voltage divider comprising two resistors and with an energy storage capacitor. There is an NPN transistor whose base is connected to the juncture of the resistors of the voltage divider. The collector of this transistor is connected to an indicating signal emitting means. The indicating signal will be present as long as the thyristor is in a blocking state and its main electrodes are subjected to either forward or reverse voltage having an instantaneous magnitude higher than the threshold level.

The voltage detecting or monitoring devices used in high voltage power converters require power supply for operation. So far, the power supply to monitoring devices in HVDC converters is being provided through a separate power tapping circuit which is integrated in the snubber circuit of the power semiconductor device. The voltage monitoring, which would include monitoring polarity of the voltage across the power semiconductor device or monitoring if the threshold voltage value has exceeded, is done via a grading resistor that is connected in parallel to the power semiconductor device.

However, having a separate power tapping circuit or an additional power supply would increase the number of components and contacts in the circuit and would thereby increase the chances of their associated failure rate.

Therefore, a need exists for a cost efficient and a compact solution for voltage polarity monitoring in a high voltage converter circuit as well as for providing power supply to the monitoring device of the same circuit without engaging any additional power supply unit or any high voltage capacitor.

It is an object of the present invention to provide for a cost efficient solution for monitoring voltage of a power semiconductor circuit of a high voltage converter circuit by a monitoring device and simultaneously supplying power to such a monitoring device without adding any external power supply unit.

The object of the invention is achieved with a high voltage converter circuit according to claim 1.

The object of the invention is achieved with a high voltage converter circuit having a plurality of power semiconductor devices connected in series. Each power semiconductor device is equipped with a monitoring device for monitoring voltage polarity across the power semiconductor device. The circuit also comprises a power supply unit which stores charge in a storage capacitor during operation of the high voltage converter circuit and supplies power to the monitoring device. The monitoring device comprises a diode rectifier circuit having two phase modules, a positive and a negative voltage monitoring unit and a power supply unit. During a positive duty cycle of operation of the circuit a positive voltage is sensed by the positive voltage monitoring unit and during a negative duty cycle of operation of the circuit a negative voltage is sensed by the negative voltage monitoring unit. Thereby, the polarity of voltage across the power semiconductor device can be determined.

According to the present invention the monitoring device and the power supply unit is separated from the snubber circuit. By using the proposed design all the components of a separate power supply circuit can be eliminated, which means the total number of all components, in particular, the high voltage components, and hence the associated failure rate can be reduced. Besides this, various contacts of the device can be eliminated, which simplifies the wiring within the high voltage converter circuit.

The power semiconductor device can be a thyristor or an IGBT.

According to the present invention, the AC terminals of the phase modules are coupled to the power semiconductor device through a connection interface, wherein the connection interface comprises two clamps. By using only two clamps the wiring of the circuit is simplified as there will only be two contacts instead of several contacts like in earlier voltage monitoring HVDC converter circuits. By eliminating multiple contacts the circuit becomes more compact and robust.

In another embodiment the power supply unit comprises a storage capacitor which is connected to at least one said phase module. This capacitor is capable of storing charge and this charge can be utilized for powering both the positive voltage monitoring unit and the negative voltage monitoring unit.

In yet another embodiment the storage capacitor is connected to at least one said phase module through at least one charging diode. For example, there are two charging diodes in the monitoring device. If the measured voltage across the sensing resistors exceeds the supply voltage, the current is fed in to the storage capacitor of the power supply unit through the charging diodes. The charging diodes are in a conducting state when there is a positive voltage sensed by the sensing resistor of the first phase module as well as when there is a negative voltage sensed by the sensing resistor of the second phase module. The charging diodes help in the unidirectional flow of the charge from the phase modules into the storage capacitor.

In another embodiment the charging diode, having a cathode terminal and an anode terminal, is connected between the power supply unit and one of the rectifier arms of one of the phase modules such that the cathode terminal of the charging diode is connected to the storage capacitor and the anode terminal of the charging diode is connected to one of the rectifier arms of one of the phase modules. This arrangement of the charging diodes prevents the charge stored in the storage capacitor from flowing out.

In another embodiment, the high voltage converter circuit comprises a snubber circuit. This snubber circuit is connected in parallel to the power semiconductor device for protecting the power semiconductor device against voltage transients. The snubber circuit comprises a snubber resistor connected in series with a snubber capacitor. The snubber capacitor is required in parallel to the power semiconductor device to handle voltage overshoots during turn off of the power semiconductor device. To damp oscillations caused by the combination of the snubber capacitor and circuit inductance, the snubber resistor is connected in series to the capacitor.

In yet another embodiment the first and the second phase modules further comprise a positive tapping resistor and a negative tapping resistor respectively. The positive tapping resistor is connected between one of the DC terminals and the sensing resistor of the first phase module and the negative tapping resistor is connected between one of the DC terminals and the sensing resistor of the second phase module. The tapping resistors divide the voltage sensed across each of the sensing resistors and keep the measured voltage within a desired range, for example, 0-5 Volts.

In a further embodiment, the high voltage converter circuit further comprises a grading resistor arranged in parallel to the power semiconductor device. One end of the grading resistor is connected to one terminal of the power semiconductor device and the other end of the grading resistor is connected to the AC terminal of any one of the phase modules. By connecting a grading resistor one can use low voltage components in a high voltage converter circuit where the voltage can be in the range of several kilo Volts. The grading resistor also ensures that the voltage across the plurality of power semiconductor devices in the high voltage converter circuit is evenly shared.

In the embodiment that is considered as the best mode for the present invention the power semiconductor device 3 is a light triggered thyristor. However, the invention also works for electrically triggered thyristors.

Additionally, the high voltage converter circuit as disclosed in the present invention can comprise some or all the features which have been mentioned above for the different embodiments of the circuit according to the invention.

The above-mentioned and other features of the invention will now be addressed with reference to the accompanying drawings of the present invention. The illustrated embodiments are intended to illustrate, but not limit the invention. The drawings contain the following figures, in which like numbers refer to like parts, throughout the description and drawings.
FIG. 1 is a schematic diagram of a high voltage converter circuit equipped with a monitoring device for monitoring voltage polarity across a power semiconductor device.
FIG. 2 is a schematic diagram of a plurality of power semiconductor devices connected in series forming the high voltage converter circuit.

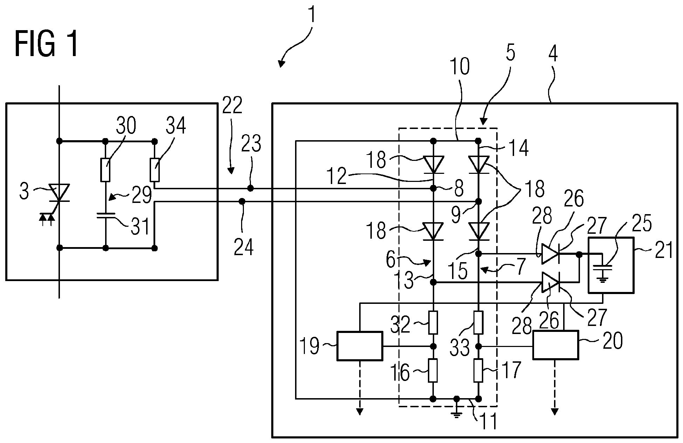

FIG. 1 illustrates a schematic diagram of the high voltage converter circuit 1 equipped with the monitoring device 4 for monitoring voltage polarity across a power semiconductor device 3 as disclosed in the present invention. The high voltage converter circuit 1 comprises the power semiconductor device 3 and the monitoring device 4. The monitoring device 4 comprises a diode rectifier circuit 5 having two phase modules, a first phase module 6 and a second phase module 7. Each phase module 6, 7 comprises an AC terminal 8, 9, DC terminals 10, 11, two rectifier arms 12, 13, 14, 15 and a sensing resistor 16, 17, one for each phase module 6, 7. Each rectifier arm 12, 13, 14, 15 comprises at least one diode 18 and each rectifier arm 12, 13, 14, 15 is connected between the AC terminal 8, 9 and one of the DC terminals 10, 11.

The first phase module 6 comprises a pair of rectifier arms 12, 13, wherein the diodes 18 of the respective rectifier arms 12, 13 are serially connected to each other in a same forward conducting orientation. Similarly, the second phase module 7 comprises the other pair of rectifier arms 14, 15, wherein the diodes 18 of the respective rectifier arms 14, 15 are serially connected in a same forward conducting orientation. The rectifier arms 12, 13, 14, 15 are arranged in a bridge rectifier configuration, wherein during a positive duty cycle of operation, i.e. when a positive voltage is supplied across the diode rectifier circuit 5, the diodes 18 from the first pair of rectifier arms 13, 14 are forward biased and are in a conducting mode while the diodes 18 from the second pair of rectifier arms 12, 15 are blocked and are not conducting. Whereas during a negative duty cycle of operation, i.e. when a negative voltage is supplied across the diode rectifier circuit 5, the pair of diodes 18 which was non-conducting during the positive duty cycle of operation from the second pair of rectifier arms 12, 15 becomes forward biased and starts to conduct and the pair of diodes 18 which was conducting during the positive duty cycle of operation from the first pair of rectifier arms 13, 14 becomes reverse biased and stops conducting.

The phase modules 6, 7 of the monitoring device 4 further comprise a pair of sensing resistors 16, 17. The first phase module comprises a positive sensing resistor 16 and the second phase module comprises a negative sensing resistor 17. The positive sensing resistor 16 is connected in series with the pair of rectifier arms 12, 13 forming a part of the first phase module and the negative sensing resistor 17 is connected in series with the pair of rectifier arms 14, 15 forming a part of the second phase module. The sensing resistors 16, 17 are connected at one end to one of the rectifier arms 13, 15 and at the other end to one of the DC terminals 11.

The positive voltage sensed across the positive sensing resistor 16 is monitored by a positive voltage monitoring unit 19 and the negative voltage sensed across the negative sensing resistor 17 is monitored by a negative voltage monitoring unit 20. The positive and the negative voltage monitoring units receive power supply from a power supply unit 21.

The monitoring device 4 has a connection interface 22 for connecting to the power semiconductor device 3. The AC terminals 8, 9 of the phase modules 6, 7 are coupled to the power semiconductor device 3 through the connection interface 22. The connection interface 22 comprises only two clamps 23, 24. Thus, reducing the number of contacts and making the system less prone to faults and connection related errors.

The power supply unit 21 comprises a storage capacitor 25. This storage capacitor 25 is connected to the phase modules 6, 7. The storage capacitor 25 is connected through at least one charging diode 26. For example, two charging diodes 26 may be engaged, each connected to the same terminal of the storage capacitor 25. The other terminal of the storage capacitor 25 is at ground potential. Each charging diode 26 connects to one of the rectifier arms 12, 13, 14, 15 of the respective phase modules 6, 7. The charging diodes 26 have a cathode terminal 27 and an anode terminal 28. The cathode terminal 27 of the charging diode 26 is connected to the storage capacitor 25 and the anode terminal 28 is connected to one of the rectifier arms 12, 13, 14, 15 of one of the phase modules 6, 7.

The high voltage converter circuit further comprises a snubber circuit 29 connected in parallel to the power semiconductor device 3. The snubber circuit 29 comprises a snubber resistor 30 connected in series with a snubber capacitor 31.

The first 6 and the second 7 phase modules of the high voltage converter circuit 1 further comprises a positive tapping resistor 32 and a negative tapping resistor 33 respectively. The positive tapping resistor 32 is connected between one of the DC terminals 10 and the sensing resistor 14 of the first phase module 6, and the negative tapping resistor 33 is connected between one of the DC terminals 11 and the sensing resistor 17 of the second phase module 7.

The high voltage converter circuit further comprises a grading resistor 34. This grading resistor 34 is connected between a power terminal of the power semiconductor device 3 and the clamp 23 of the interface 22. Due to the grading resistor 34 the voltage between the clamps 23, 24 of the interface 22 can be reduced considerably, so that low voltage components can be used for the monitoring device 4. In other words, the grading resistor 34 is arranged in parallel to the power semiconductor device 3 and is connected to the AC terminal 8, 9 of any one of the phase modules 6, 7.

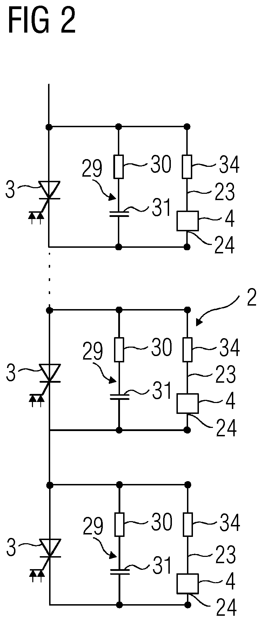

Referring now to FIG. 2, it illustrates a schematic diagram of a plurality 2 of power semiconductor devices connected in series forming the high voltage converter circuit 1. The figure shows multiple power semiconductor devices 3 each having a snubber circuit 29, a grading resistor 34 and a monitoring device 4. The snubber circuit 29 is connected in parallel to the power semiconductor device 3. Each snubber circuit 29 comprises a snubber resistor 30 and a snubber capacitor 31 connected in series. The grading resistor 34 for each of the power semiconductor devices 3 is also connected in parallel to the power semiconductor device 3. For example, there can be a series of 60 power semiconductor devices connected in series. The monitoring device 4 is connected in parallel to the power semiconductor device 3 and is serially connected to the grading resistor 34 through the clamp 23.

### List of reference signs

- 1: high voltage converter circuit
- 2: plurality of power semiconductor devices
- 3: power semiconductor device
- 4: monitoring device
- 5: diode rectifier circuit
- 6: first phase module
- 7: second phase module
- 8: AC terminal
- 9: AC terminal
- 10: DC terminal
- 11: DC terminal
- 12: rectifier arm
- 13: rectifier arm
- 14: rectifier arm
- 15: rectifier arm
- 16: sensing resistance
- 17: sensing resistance
- 18: diode
- 19: positive voltage monitoring unit
- 20: negative voltage monitoring unit
- 21: power supply unit
- 22: connection interface
- 23: clamp
- 24: clamp
- 25: storage capacitor
- 26: charging diode
- 27: cathode terminal
- 28: anode terminal
- 29: snubber circuit
- 30: snubber resistor
- 31: snubber capacitor
- 32: positive tapping resistor
- 33: negative tapping resistor
- 34: grading resistor

## Claims

1. A high voltage converter circuit (1) providing a plurality (2) of power semiconductor devices connected in series, each power semiconductor device (3) is equipped with a monitoring device (4) for monitoring voltage polarity across the power semiconductor device (3), the monitoring device (4) comprises:
- a diode rectifier circuit (5) having a first (6) and a second (7) phase module;
- each phase module (6, 7) comprises an AC terminal (8, 9), DC terminals (10, 11), two rectifier arms (12, 13, 14, 15) and a sensing resistor (16, 17);
- each rectifier arm (12, 13, 14, 15) is connected between the AC terminal (8, 9) and one of the DC terminals (10, 11) and comprises at least one diode (18) ;
- the sensing resistor (16, 17) of each phase module (6, 7) is connected in series with the diode(s) (18) of the corresponding rectifier arms (12, 13, 14, 15) of each phase module (6, 7), such that during a positive duty cycle of operation of the circuit (4) a voltage is sensed across the sensing resistor (16) connected to the first phase module (6) and during a negative duty cycle of operation of the circuit (4) a voltage is sensed across the sensing resistor (17) connected to the second phase module (7);
- a positive voltage monitoring unit (19) for monitoring the voltage sensed across the sensing resistor (16) of the first phase module (6);
- a negative voltage monitoring unit (20) for monitoring the voltage sensed across the sensing resistor (17) of the second phase module (7);
- a power supply unit (21) connected with a connection point between the diodes of the rectifier arms of a phase module and the sensing resistor of the phase module;
- the DC terminals (10, 11) of the first (6) and the second (7) phase module are electrically connected with each other and have ground potential;
- the sensing resistors (16, 17) are connected at one end to one of the rectifier arms (13, 15) and at the other end to one of the DC terminals (11);
wherein the AC terminals (8, 9) of the phase modules (6, 7) are coupled to the power semiconductor device (3) through a connection interface (22), wherein the connection interface (22) comprises two clamps (23, 24).

2. The high voltage converter circuit (1) according to claim 1, wherein the power supply unit (21) comprises a storage capacitor (25) which is connected to at least one said phase module (6, 7).

3. The high voltage converter circuit (1) according to claim 2, wherein the storage capacitor (25) is connected to at least one said phase module (6, 7) through at least one charging diode (26).

4. The high voltage converter circuit (1) according to claim 3, wherein the charging diode (26), having an anode terminal (27) and a cathode terminal (28), is connected between the power supply unit (21) and one of the rectifier arms (12, 13, 14, 15) of one of the phase modules (6, 7) such that the cathode terminal (27) of the charging diode (26) is connected to the storage capacitor (25) and the anode terminal (28) of the charging diode (28) is connected to one of the rectifier arms (12, 13, 14, 15) of one of the phase modules (6, 7).

5. The high voltage converter circuit (1) according to any one of the preceding claims comprising a snubber circuit (29) connected in parallel to the power semiconductor device (3) for protecting the power semiconductor device (3) against voltage transients, wherein the snubber circuit (29) comprises a snubber resistor (30) connected in series with a snubber capacitor (31).

6. The high voltage converter circuit (1) according to any one of the preceding claims, wherein the first (6) and the second (7) phase modules further comprise a positive tapping resistor (32) and a negative tapping resistor (33) respectively, wherein the positive tapping resistor (32) is connected between one of the rectifier arms (13) and the sensing resistor (14) of the first phase module (6), and the negative tapping resistor (33) is connected between one of the rectifier arms (15) and the sensing resistor (17) of the second phase module (7).

7. The high voltage converter circuit (1) according to any one of the preceding claims, wherein a grading resistor (34) is connected between a power terminal of the power semiconductor device (3) and the clamp (23) of the interface (22) .

## Patentansprüche

1. Hochspannungswandlerschaltung (1), die eine Vielzahl (2) von in Reihe geschalteten Leistungshalbleiterbauelementen bereitstellt, wobei jedes Leistungshalbleiterbauelement (3) mit einer Überwachungsvorrichtung (4) zum Überwachen der Spannungspolarität über dem Leistungshalbleiterbauelement (3) ausgestattet ist, wobei die Überwachungsvorrichtung (4) umfasst:
- eine Diodengleichrichterschaltung (5), die ein erstes (6) und ein zweites (7) Phasenmodul aufweist;
- wobei jedes Phasenmodul (6, 7) einen Wechselstromanschluss (8, 9), Gleichstromanschlüsse (10, 11), zwei Gleichrichterarme (12, 13, 14, 15) und einen Abtastwiderstand (16, 17) umfasst;
- wobei jeder Gleichrichterarm (12, 13, 14, 15) zwischen dem Wechselstromanschluss (8, 9) und einem der Gleichstromanschlüsse (10, 11) verbunden ist und mindestens eine Diode (18) umfasst;
- wobei der Abtastwiderstand (16, 17) jedes Phasenmoduls (6, 7) in Reihe mit der bzw. den Dioden (18) der korrespondierenden Gleichrichterarme (12, 13, 14, 15) jedes Phasenmoduls (6, 7) verbunden ist, so dass während eines positiven Arbeitszyklus des Betriebs der Schaltung (4) eine Spannung über dem Abtastwiderstand (16), der mit dem ersten Phasenmodul (6) verbunden ist, und während eines negativen Arbeitszyklus des Betriebs der Schaltung (4) eine Spannung über dem Abtastwiderstand (17), der mit dem zweiten Phasenmodul (7) verbunden ist, abgetastet wird;
- eine positive Spannungsüberwachungseinheit (19) zum Überwachen der über dem Abtastwiderstand (16) des ersten Phasenmoduls (6) abgetasteten Spannung;
- eine negative Spannungsüberwachungseinheit (20) zum Überwachen der über dem Abtastwiderstand (17) des zweiten Phasenmoduls (7) abgetasteten Spannung;
- eine Leistungsversorgungseinheit (21), die mit einem Verbindungspunkt zwischen den Dioden der Gleichrichterarme eines Phasenmoduls und dem Abtastwiderstand des Phasenmoduls verbunden ist;
- wobei die Gleichstromanschlüsse (10, 11) des ersten (6) und des zweiten (7) Phasenmoduls elektrisch miteinander verbunden sind und Erdpotential aufweisen;
- wobei die Abtastwiderstände (16, 17) an einem Ende mit einem der Gleichrichterarme (13, 15) und an dem anderen Ende mit einem der Gleichstromanschlüsse (11) verbunden sind;
wobei die Wechselstromanschlüsse (8, 9) der Phasenmodule (6, 7) durch eine Verbindungsschnittstelle (22) an das Leistungshalbleiterbauelement (3) gekoppelt sind, wobei die Verbindungsschnittstelle (22) zwei Klemmen (23, 24) umfasst

2. Hochspannungswandlerschaltung (1) nach Anspruch 1, wobei die Leistungsversorgungseinheit (21) einen Speicherkondensator (25) umfasst, der mit mindestens einem der Phasenmodule (6, 7) verbunden ist.

3. Hochspannungswandlerschaltung (1) nach Anspruch 2, wobei der Speicherkondensator (25) durch mindestens eine Ladediode (26) mit mindestens einem der Phasenmodule (6, 7) verbunden ist.

4. Hochspannungswandlerschaltung (1) nach Anspruch 3, wobei die Ladediode (26), die einen Anodenanschluss (27) und einen Kathodenanschluss (28) aufweist, zwischen der Leistungsversorgungseinheit (21) und einem der Gleichrichterarme (12, 13, 14, 15) eines der Phasenmodule (6, 7) derart verbunden ist, dass der Kathodenanschluss (27) der Ladediode (26) mit dem Speicherkondensator (25) verbunden ist und der Anodenanschluss (28) der Ladediode (28) mit einem der Gleichrichterarme (12, 13, 14, 15) eines der Phasenmodule (6, 7) verbunden ist.

5. Hochspannungswandlerschaltung (1) nach einem der vorhergehenden Ansprüche, umfassend eine Begrenzungsschaltung (29), die parallel zu dem Leistungshalbleiterbauelement (3) verbunden ist, zum Schützen des Leistungshalbleiterbauelements (3) vor Spannungsübergängen, wobei die Begrenzungsschaltung (29) einen Begrenzungswiderstand (30) umfasst, der mit einem Begrenzungskondensator (31) in Reihe geschaltet ist

6. Hochspannungswandlerschaltung (1) nach einem der vorhergehenden Ansprüche, wobei das erste (6) und das zweite (7) Phasenmodul ferner einen positiven Anzapfwiderstand (32) bzw. einen negativen Anzapfwiderstand (33) umfassen, wobei der positive Anzapfwiderstand (32) zwischen einem der Gleichrichterarme (13) und dem Abtastwiderstand (14) des ersten Phasenmoduls (6) verbunden ist und der negative Anzapfwiderstand (33) zwischen einem der Gleichrichterarme (15) und dem Abtastwiderstand (17) des zweiten Phasenmoduls (7) verbunden ist

7. Hochspannungswandlerschaltung (1) nach einem der vorhergehenden Ansprüche, wobei ein Abstufungswiderstand (34) zwischen einem Leistungsanschluss des Leistungshalbleiterbauelements (3) und der Klemme (23) der Schnittstelle (22) verbunden ist.

## Revendications

1. Circuit (1) de convertisseur de haute-tension fournissant une pluralité (2) de dispositifs à semi-conducteur de puissance montés en série, chaque dispositif (3) à semi-conducteur de puissance étant équipé d'un dispositif (4) de contrôle pour contrôler la polarité de la tension aux bornes du dispositif (3) à semi-conducteur de puissance, le dispositif (4) de contrôle comprenant :
- un circuit (5) redresseur à diode ayant un premier (6) et un deuxième (7) modules de phase ;
- chaque module (6, 7) de phase comprend une borne (8, 9) de courant alternatif, des bornes (10, 11) de courant continu, deux bras (12, 13, 14, 15) redresseurs et une résistance (16, 17) de détection ;
- chaque bras (12, 13, 14, 15) redresseur est connecté entre la borne (8, 9) de courant alternatif et l'une des bornes (10, 11) de courant continu et comprend au moins une diode (18) ;
- la résistance (16, 17) de détection de chaque module (6, 7) de phase est montée en série avec la ou les diode(s) (18) des bras (12, 13, 14, 15) redresseurs correspondants de chaque module (6, 7) de phase, de manière à détecter pendant un rapport cyclique positif de fonctionnement du circuit (4), une tension aux bornes de la résistance (16) de détection connectée au premier module (6) de phase et à détecter, pendant un rapport cyclique négatif de fonctionnement de circuit (4), une tension aux bornes de la résistance (17) de détection connectée au deuxième module (7) de phase ;
- une unité (19) de contrôle de la tension positive pour contrôler la tension détectée aux bornes de la résistance (16) de détection du premier module (6) de phase ;
- une unité (20) de contrôle de la tension négative pour contrôler la tension détectée aux bornes de la résistance (17) de détection du deuxième module (16) de phase ;
- une unité (21) d'alimentation en courant connectée à un point de connexion entre les diodes des bras redresseurs d'un module de phase et la résistance de détection du module de phase ;
- les bornes (10, 11) de courant continu du premier (6) et du deuxième (7) modules de phase sont connectées électriquement l'une à l'autre et ont un potentiel de terre ;
- les résistances (16, 17) de détection sont connectées, à une extrémité, à l'un des bras (13, 15) redresseurs et, à l'autre extrémité, à l'une des bornes (11) de courant continu ;
dans lequel les bornes (8, 9) de courant alternatif des modules (6, 7) de phase sont couplées au dispositif (3) à semi-conducteur de puissance par une interface (22) de connexion, l'interface (22) de connexion comprenant deux coupleurs (23, 24).

2. Circuit (1) de convertisseur de haute-tension suivant la revendication 1,
dans lequel l'unité (21) d'alimentation en courant comprend un condensateur (25) d'accumulation, qui est connecté au au moins un module (6, 7) de phase.

3. Circuit (1) de convertisseur de haute-tension suivant la revendication 2, dans lequel le condensateur (25) d'accumulation est connecté au au moins un module (6, 7) de phase par l'intermédiaire d'au moins une diode (26) de charge.

4. Circuit (1) de convertisseur de haute-tension suivant la revendication 3, dans lequel la diode (26) de charge, ayant une borne (27) d'anode et une borne (28) de cathode, est montée entre l'unité (21) d'alimentation en courant et l'un des bras (12, 13, 14, 15) redresseurs de l'un des modules (6, 7) de phase de manière à ce que la borne (27) de cathode de la diode (26) de charge soit connectée au condensateur (25) d'accumulation et de manière à ce que la borne (28) d'anode de la diode (28) de charge soit connectée à l'un des bras (12, 13, 14, 15) redresseurs de l'un des modules (6, 7) de phase.

5. Circuit (1) de convertisseur de haute-tension suivant l'une quelconque des revendications précédentes, comprenant un circuit (29) d'amortissement monté en parallèle au dispositif (3) à semi-conducteur de puissance pour protéger le dispositif (3) à semi-conducteur de puissance de transitoires de tension, le circuit (29) d'amortissement comprenant une résistance (30) d'amortissement montée en série avec un condensateur (31) d'amortissement.

6. Circuit (1) de convertisseur de haute-tension suivant l'une des revendications précédentes, dans lequel le premier (6) et le deuxième (7) modules de phase comprennent en outre une résistance (32) de prélèvement positif et une résistance (33) de prélèvement négatif respectivement, dans lequel la résistance (32) de prélèvement positif est montée entre l'un des bras (13) redresseurs et la résistance (14) de détection du premier module (6) de phase et la résistance (33) de prélèvement négatif est monté entre l'un des bras (15) redresseurs et la résistance (17) de détection du deuxième module (7) de phase.

7. Circuit (1) de convertisseur de haute-tension suivant l'une des revendications précédentes, dans lequel une résistance (34) de gradation est montée entre une borne de puissance du dispositif (3) à semi-conducteur de puissance et le coupleur (23) de l'interface (22) .
